# EUROPEAN PATENT APPLICATION

(11) **EP 4 199 054 A2**
(43) Date of publication of application: **21.06.2023**
(21) Application number: 22213217.7
(22) Date of filing: 13.12.2022
(51) Int. Cl.: H01L 21/768, H01L 23/48, H01L 23/522, H01L 23/528, H01L 23/535

(54) **REPLACEMENT DEEP VIA AND BURIED OR BACKSIDE POWER RAIL WITH BACKSIDE INTERCONNECT STRUCTURE**

(30) Priority: 20.12.2021 US 202117556422
(71) Applicant: INTEL Corporation, Santa Clara, CA 95054 (US)
(72) Inventor: MURTHY, Anand S., Portland, 97229 (US); MAJHI, Prashant, San Jose, 95121 (US)
(74) Representative: 2SPL Patentanwälte PartG mbB

(57) **Abstract**

An integrated circuit structure includes a device layer including a plurality of transistors, a first interconnect feature vertically extending through the device layer, and an interconnect structure below the device layer. The interconnect structure below the device layer includes at least a second interconnect feature. In an example, the second interconnect feature is conjoined with the first interconnect feature. For example, the first and second interconnect features collectively form a continuous and monolithic body of conductive material.

## Description

### BACKGROUND

Fabrication of microelectronic devices involves forming electronic components on microelectronic substrates, such as silicon wafers. These electronic components may include transistors, resistors, capacitors, and other active and passive devices, with overlying interconnect features (e.g., vias and lines) to route signals and power to and/or from the electronic components. Scaling of microelectronic devices results in high density of scaled interconnect features. One approach to circumvent congestion of front side interconnects due to power and signal routing includes the use of a backside power delivery network (PDN) and buried or backside power rail (BPR) technology. However, there remain a number of non-trivial challenges with respect to scaled interconnects.

### BRIEF DESCRIPTION OF THE DRAWINGS

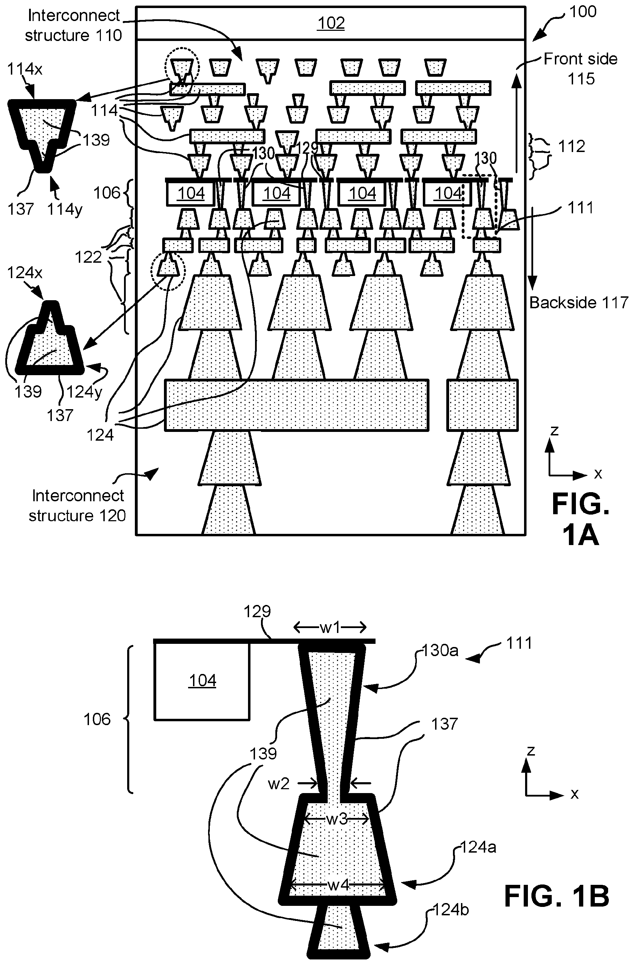

Fig. 1A illustrates a cross sectional view of a section of an integrated circuit (IC) comprising a device layer including a plurality of active and/or passive devices, wherein one or more first interconnect features extend vertically through the device layer and conjoin with corresponding one or more backside interconnect features on a backside of the device layer, and wherein one of the first interconnect features and one of the backside interconnect features conjoin and collectively form a continuous and monolithic body of conductive material, in accordance with an embodiment of the present disclosure.
Fig. 1B illustrates a magnified view of a section of the IC of Fig. 1A, in accordance with an embodiment of the present disclosure.
Fig. 2 illustrates a flowchart depicting a method of forming an IC (such as the IC of Figs. 1A and 1B) comprising a device layer, and where one or more first interconnect features extend vertically through the device layer and conjoins with corresponding one or more backside interconnect features on a backside of the device layer, wherein one of the first interconnect features and one of the backside interconnect features conjoin and collectively form a continuous and monolithic body of conductive material, in accordance with an embodiment of the present disclosure.
Figs. 3A-3H illustrate cross-sectional views of an IC (such as the IC of Figs. 1A, 1B, and 2) in various stages of processing, in accordance with an embodiment of the present disclosure.

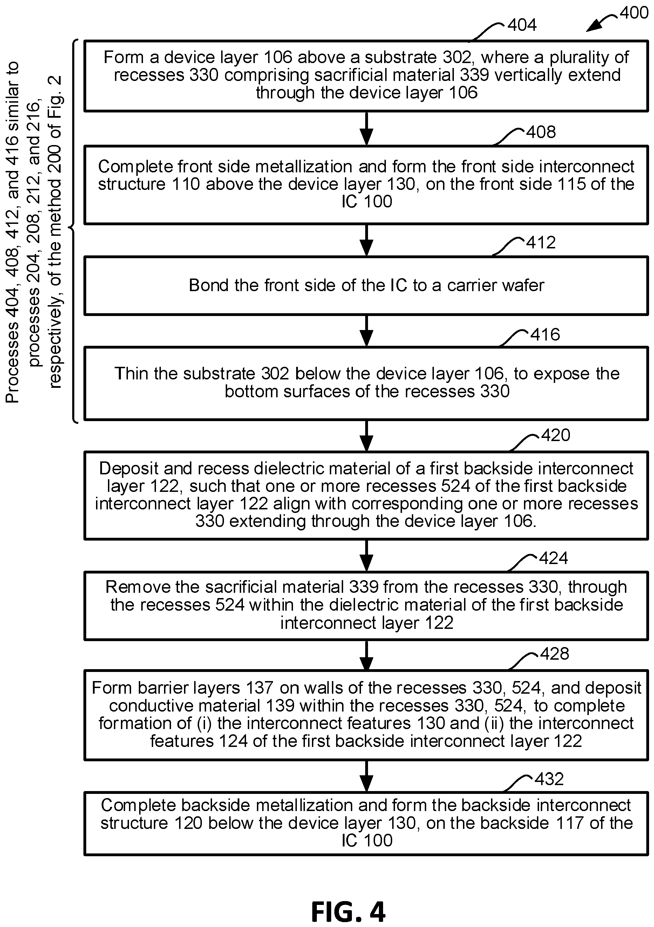

Fig. 4 illustrates a flowchart depicting a method of forming an IC (such as the IC of Figs. 1A and 1B) comprising a device layer and one or more first interconnect features extending vertically through the device layer and conjoining with corresponding one or more backside interconnect features on a backside of the device layer, wherein one of the first interconnect features and one of the backside interconnect features conjoin and collectively form a continuous and monolithic body of conductive material, and wherein the continuous and monolithic body of conductive material is formed during a same deposition process step, in accordance with an embodiment of the present disclosure.
Figs. 5A-5F illustrate cross-sectional views of an IC (such as the IC of Figs. 1A, 1B, and 4) in various stages of processing, in accordance with an embodiment of the present disclosure.
Fig. 6 illustrates a computing system implemented with integrated circuit structures having one or more interconnect features formed using the techniques disclosed herein, in accordance with some embodiments of the present disclosure.

These and other features of the present embodiments will be understood better by reading the following detailed description, taken together with the figures herein described. In the drawings, each identical or nearly identical component that is illustrated in various figures may be represented by a like numeral. For purposes of clarity, not every component may be labeled in every drawing. Furthermore, as will be appreciated, the figures are not necessarily drawn to scale or intended to limit the described embodiments to the specific configurations shown. For instance, while some figures generally indicate straight lines, right angles, and smooth surfaces, an actual implementation of the disclosed techniques may have less than perfect straight lines and right angles (e.g., curved or tapered sidewalls and round corners), and some features may have surface topography or otherwise be non-smooth, given real-world limitations of fabrication processes. Further still, some of the features in the drawings may include a patterned and/or shaded fill, which is merely provided to assist in visually identifying the different features. In short, the figures are provided merely to show example structures.

### DETAILED DESCRIPTION

Provided herein is an integrated circuit structure including one or more conductive interconnect features vertically extending through a device layer, where the conductive interconnect features couple a backside interconnect structure to one or more active devices of the device layer, and/or to a front side interconnect structure. In some embodiments, one of the conductive interconnect features is conjoined with a corresponding backside interconnect feature of the backside interconnect structure, such that the conductive interconnect feature and the backside interconnect feature collectively form a continuous and monolithic body of conductive material. In an example, the conductive material is copper.

In one such example embodiment, an integrated circuit device includes a device layer including a plurality of transistors, a first interconnect feature vertically extending through the device layer, and a backside interconnect structure below the device layer. The backside interconnect structure below the device layer includes at least a backside interconnect feature. In an example, the backside interconnect feature is conjoined with the first interconnect feature. For example, the first and backside interconnect features collectively form a continuous and monolithic body of conductive material. In an example, the integrated circuit device further includes a front side interconnect structure above the device layer and including at least a front side interconnect feature. In an example, the first interconnect feature couples the backside interconnect feature with the front side interconnect feature. In another example, the first interconnect feature couples the backside interconnect feature with a transistor of the device layer.

In another embodiment, an integrated circuit device includes a first interconnect feature tapered towards the bottom, and a second interconnect feature tapered towards the top. In an example, a first width of the first interconnect feature measured at or near a top surface of the first interconnect feature is at least 5% greater than a second width of the first interconnect feature measured at or near a bottom surface of the first interconnect feature. In an example, a third width of the second interconnect feature measured at or near a top surface of the second interconnect feature is at least 5% less than a fourth width of the second interconnect feature measured at or near a bottom surface of the second interconnect feature. The first, second, third, and fourth widths are measured in a horizontal direction that is perpendicular to an imaginary line passing through the first and second interconnect features. In an example, the first and second interconnect features collectively form a continuous and monolithic body of conductive material.

In another embodiment, a microelectronic device includes a device layer comprising a plurality of transistors, and a backside interconnect structure below the device layer and on a backside of the plurality of transistors. In an example, the backside interconnect structure comprises a plurality of backside interconnect features including a first backside interconnect feature. The microelectronic device further includes a front side interconnect structure above the device layer and on a front side of the plurality of transistors. In an example, the front side interconnect structure comprises a plurality of front side interconnect features including a first front side interconnect feature. The microelectronic device further includes an intermediate interconnect feature between the backside interconnect structure and the front side interconnect structure and extending at least in part through the device layer. In an example, the intermediate interconnect feature couples the first backside interconnect feature and the first front side interconnect feature. In an example, the intermediate interconnect feature and the first backside interconnect feature are conjoined, such that there is no intervening layer between conductive materials of the intermediate interconnect feature and the first backside interconnect feature.

In yet another embodiment, a method of forming an integrated circuit comprises forming, on a substrate, a device layer comprising a plurality of transistors and a recess filed with sacrificial material, and forming a front side interconnect structure above the device layer and including one or more front side interconnect layers. In an example, the one or more front side interconnect layers include front side conductive interconnect features. The method further includes removing a section of the substrate under the device layer, so as to expose a bottom surface of the recess and removing the sacrificial material from the recess and forming an intermediate interconnect feature within the recess. The method further includes forming a backside interconnect structure below the device layer. In an example, the backside interconnect structure includes one or more backside interconnect layers. In an example, the one or more backside interconnect layers includes backside conductive interconnect features. In an example, a first backside conductive interconnect feature conjoins with the intermediate interconnect feature to collectively form a continuous and monolithic body of conductive material. Numerous variations, embodiments, and applications will be apparent in light of the present disclosure.

### General Overview

As previously noted, non-trivial issues remain with respect to implementing buried or backside power rail (BPR) and backside power delivery network (PDN) architecture. For instance, an IC with BPRs and/or a backside PDN may include deep conductive vias extending vertically through the device layer. The deep conductive vias couple the backside PDN and/or BPR to the device layer and/or to a front side interconnect structure. The BPR is a buried power rail (e.g., buried within or below the device layer) supplying power to one or more devices of the device layer. In general, the deep conductive vias extending through the device layer are formed prior to, or concurrent with, formation of one or more transistors of the device layer. Hence, the deep conductive vias extending through the device layer have to withstand relatively high temperature processing of the transistors of the device layer. This limits the choice of conductive materials for the deep conductive vias to only those conductive materials that can sustain high thermal budget (such as ruthenium, molybdenum, cobalt, tungsten), which are not necessarily relatively low resistance conductive material (such as copper). Use of such conductive materials (e.g., that can sustain high thermal budget but are not necessarily relatively low resistance conductive material) for the deep conductive vias increase the resistance of the deep conductive vias, thereby degrading the performance of the IC device.

Accordingly, techniques are provided herein to form an IC that uses sacrificial material to fill recesses extending through a device layer, and later (e.g., after formation of the transistors of the device layer), the sacrificial material within the recesses are replaced by conductive material, to form the deep conductive vias. Thus, the replacement conductive material of the deep conductive vias does not have to withstand various high temperature processes for formation of transistors in the device layer. Accordingly, conductive materials that may not sustain high temperature process and that are relatively low in resistance, such as copper, can be used as replacement conductive material for the deep conductive vias. Use of such replacement conductive material reduces the resistance of the deep conductive vias (e.g., compared to a scenario where high thermal budget and relatively high resistance conductive material had to be used for the vias).

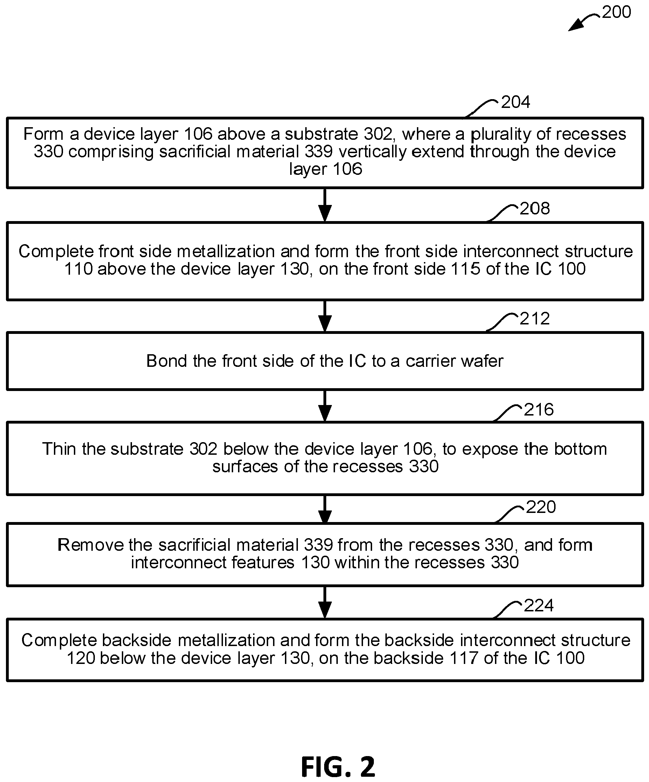

Additionally, when replacing the sacrificial material of the recesses with the replacement conductive material, in an example (e.g., see Figs. 2-3H), the conductive material of the deep conductive vias may not be capped with a barrier or encapsulation layer. Rather, a deep conductive via may be conjoined with a corresponding backside interconnect feature of a backside interconnect structure, to collectively form a continuous and monolithic body of conductive material, i.e., without any barrier, liner, or encapsulation layer between the conductive materials of the deep conductive via and the backside interconnect feature. In another example (e.g., see Figs. 4-5F), a first recess (e.g., comprising sacrificial material) for a corresponding deep conductive via can be conjoined with a second recess for a backside interconnect feature, and the sacrificial material within the first recess is removed through the second recess. Subsequently, a barrier layer is deposited on walls of the first and second recesses during a common deposition process, and conductive material is deposited within the first and second recesses during a common deposition process. Such process flow also results in the resultant deep conductive via and the backside interconnect feature to have a continuous and monolithic body of conductive material, i.e., without any barrier, liner, or encapsulation layer between the conductive materials of the deep conductive via and the backside interconnect feature.

Not having any barrier, liner, or encapsulation layer between the conductive materials of the deep conductive via and the backside interconnect feature, as discussed above, further reduces the resistance of the deep conductive vias.

Thus, in an example, the resultant IC has a device layer comprising a plurality of active devices, such as transistors. A first interconnect structure is above the device layer. The first interconnect structure is a front side interconnect structure (e.g., as it is on front side of the active devices of the device layer), and includes one or more front side interconnect layers. The one or more front side interconnect layers include front side conductive interconnect features.

A second interconnect structure is below the device layer. The second interconnect structure is a backside interconnect structure (e.g., as it is on back side of the active devices of the device layer) and includes one or more back side interconnect layers. The one or more back side interconnect layers include back side conductive interconnect features.

The IC further includes a plurality of interconnect features (also referred to as intermediate interconnect features) extending through the device layer, where at least some of the intermediate interconnect features are the above discussed deep conductive vias, for example. In an example, the intermediate interconnect features are between the backside interconnect structure and the front side interconnect structure, and extends at least in part through the device layer.

In one embodiment, the IC comprises input/output (I/O) pins below the backside interconnect structure. Thus, for example, the IC communicates with a printed circuit board (PCB) through the I/O pins on the backside of the IC.

In one embodiment, the IC further comprises a substrate above the front side interconnect structure, on a front side of the IC. The substrate acts as a carrier wafer to provide mechanical integrity during a thinning process of a backside sacrificial substrate, and also during formation of the backside interconnect structure. As discussed, the IC is accessed by the PCB through I/O pins on the backside of the IC.

In an example, one or more of the intermediate interconnect features (e.g., conductive deep vias) extending through the device layer couple the backside interconnect structure to (i) one or more active devices (such as transistors) of the device layer and/or (ii) the front side interconnect structure. In an example, at least a part of the backside interconnect structure is used to deliver power to the transistors (such as a backside PDN), and one or more of the intermediate interconnect features supply power from the backside PDN and BPRs to the transistors of the device layer. In an example, the backside interconnect structure (i) routes signals between the plurality of transistors of the device layer, (ii) routes signals from or to one or more I/O pins, and/or (iii) supplies power to the plurality of transistors of the device layer. In an example, the front side interconnect structure routes signals between the plurality of transistors of the device layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools may be used to detect interconnect features (e.g., deep vias) extending through device layer, and where such an interconnect feature is conjoined to a corresponding backside interconnect feature of a backside interconnect structure, such that the interconnect feature and the backside interconnect feature collectively form a continuous and monolithic body of conductive material. In some such embodiments, such tools may also be used to detect use of copper (or another appropriate conductive material) for the interconnect features extending through device layer.

Numerous configurations and variations will be apparent in light of this disclosure.

### Architecture and Methodology

Fig. 1A illustrates a cross sectional view of a section of an integrated circuit (IC) 100 comprising a device layer 106 including a plurality of active and/or passive devices (such as transistors 104), wherein one or more first interconnect features 130 extend vertically through the device layer 106 and conjoin with corresponding one or more backside interconnect features 124 on a backside of the device layer 106, and wherein one of the first interconnect features 130 and one of the backside interconnect features 124 conjoin and collectively form a continuous and monolithic body of conductive material, in accordance with an embodiment of the present disclosure. Fig. 1B illustrates a magnified view of a section 111 of the IC 100 of Fig. 1A, in accordance with an embodiment of the present disclosure.

Referring to Fig. 1A, as illustrated, the device layer 106 includes a plurality of active and/or passive devices, such as transistors 104. The device layer 106 may represent a region that includes active and passive devices, such as transistors, resistors, capacitors, inductors, and/or other types of active or passive devices. In an example, the device layer 106 may include dielectric material, such as interlayer dielectric (ILD), at least in part encapsulating the transistors 104. The device layer 106, in an example, may also include a substrate on which the transistors are formed. Although merely four transistors 104 are illustrated to be included in the device layer 106, the device layer 106 is likely to include a larger number of transistors. Individual ones of the transistors 104 can be of any appropriate type, such as a planar or a nonplanar transistor, such as a FinFET, a forksheet transistor, a gate all around (GAA) transistor such as a nanoribbon transistor, a nanowire transistor, a nanosheet transistor, or another appropriate type of transistor. In an example, individual transistor 104 may include structures such as channel region, source region, drain region, and gate stack. The transistors 104 are symbolically illustrated in Fig. 1A using a rectangular shape, without illustrating the detailed structure of the transistors. In an example, in addition to (or instead of) the transistors 104, the device layer 106 may also include one or more other electronic components, such as diodes, resistors, capacitors, inductors.

In the orientation of the IC 100 illustrated in Fig. 1A, a section of the IC 100 above the device layer 106 is referred to herein as a front side 115 of the device layer 106, and another section of the IC 100 below the device layer 106 is referred to herein as a backside 117 of the of the device layer 106. The front side 115 and backside 117 are symbolically illustrated in Fig. 1A using respective arrows. In an example, the front side 115 and the backside 117 are respectively the front and backsides of individual transistors 104.

In one embodiment, the front side 115 of the IC 100 comprises a plurality of interconnect layers 112 (also referred to herein as "front side interconnect layers 112") forming an interconnect structure 110 (also referred to herein as "front side interconnect structure 110"). Individual interconnect layer 112 comprises dielectric material and corresponding one or more conductive interconnect features 114. For example, the interconnect layers 112 comprise various front side metallization levels. Thus, the interconnect structure 110 on the front side 115 comprises the plurality of conductive interconnect features 114. The conductive interconnect features 114 are, for example, conductive vias, conductive lines, and/or other suitable types of interconnect features. In an example, these interconnect features 114 are used to route signals and/or power between various devices (such as transistors 104) in the device layer 106 of the IC 100.

In one embodiment, the backside 117 of the IC 100 comprises a plurality of interconnect layers 122 (also referred to herein as "backside interconnect layers 112") forming a backside interconnect structure 120. Individual interconnect layer 122 comprise dielectric material and corresponding one or more conductive backside interconnect features 124. For example, the interconnect layers 122 comprise various backside metallization levels. Thus, the interconnect structure 120 on the backside 117 comprises the plurality of conductive interconnect features 124. The conductive interconnect features 124 are, for example, conductive vias, conductive lines, and/or other suitable types of interconnect features. In an example, these interconnect features 124 are used to route signals and power to and/or from various devices (such as transistors 104) in the device layer 106 of the IC 100.

In an example, the IC 100 is accessed by outside circuits (such as a printed circuit board) from the backside 117. For example, the IC 100 comprises a substrate 102, which also acts as a carrier wafer during formation of the IC 100. For the orientation illustrated in Fig. 1A, the substrate 102 is on a top section of the IC 100. For example, the substrate 102 is above and bonded to the front side interconnect structure 110. As illustrated, in an example, the front side interconnect structure 110 may not extend through the substrate 102. Accordingly, in such an example, the IC 100 is accessed by outside circuits from the backside. However, in another example, one or more interconnect features 114 of the front side interconnect structure 110 may extend through the substrate 102, and the IC 100 may be accessed by outside circuits from the front side 115 as well.

In the example where the IC 100 is accessed by outside circuits through a bottom surface of the backside 117, the interconnect features 114 of the front side interconnect structure 110 is for routing signals between the components of the device layer 106. For example, the interconnect features 114 of the front side interconnect structure 110 routes signals between the plurality of transistors 104 of the device layer 106.

In an example, the interconnect features 124 of the backside interconnect structure 120 is for (i) routing signals between the components of the device layer 106, and/or (ii) routing signals to and/or from one or more input/output pins (I/O) of the IC 100 (the I/O pins are not illustrated). Thus, the I/O pins are on the backside 117 of the IC 100 (i.e., below the backside interconnect structure 120), through which the IC 100 communicates with external circuits and components, such as a printed circuit board (PCB).

In an example, at least a section of the backside interconnect structure 120 is used to deliver power to the components (e.g., transistors 104) of the device layer 106. Thus, at least the section of the backside interconnect structure 120 acts as a backside power delivery network (PDN) for the IC 100.

Left side of Fig. 1 illustrates a magnified view of two interconnect features 114x and 114y on the front side 115 of the IC 100, and a magnified view of two other interconnect features 124x and 124y on the backside 117 of the IC 100.

The interconnect feature 114x may be a conductive line traversing into or out of the plane of the paper in which the figure is drawn. The interconnect feature 114y may be a conductive via coupling the conductive line 114x to another line. As illustrated, each of the interconnect features 114x, 114y comprises conductive material 139 within a recess, where the recess is within dielectric material of the corresponding interconnect layer 112. A barrier layer 137 is on walls of the interconnect features 114x, 114y. Thus, each of the conductive interconnect features 114x, 114y comprise the conducive material 139, and the barrier layer 137 that separates the conductive material 139 of the interconnect feature from adjacent dielectric material of the corresponding interconnect layer 112.

In an example, no barrier layer may be present between the conductive materials of the interconnect features 114x and 114y, as illustrated in Fig. 1A. In another example and contrary to the illustrations of Fig. 1A, the barrier layer 137 may be present between the conductive materials of the interconnect features 114x and 114y.

The interconnect features 124x, 124y also have similar structures, e.g., each comprises conductive material 139, and a barrier layer 137 that separates the conductive material 139 of the interconnect feature from adjacent dielectric material of the corresponding interconnect layer 122. The interconnect feature 124y may be a conductive line traversing into or out of the plane of the paper in which the figure is drawn. and the interconnect feature 124x may be a conductive via coupling the conductive line 124y to another line.

In an example, no barrier layer may be present between the conductive materials of the interconnect features 124 and 124y, as illustrated in Fig. 1A. In another example and contrary to the illustrations of Fig. 1A, the barrier layer 137 may be present between the conductive materials of the interconnect features 124x and 124y.

In an example, the conductive material 139 within interconnect features 114, 124 tends to diffuse through the adjacent dielectric material of the corresponding interconnect layer. In an example where the conductive material 139 is copper, the diffusion may result in formation of undesirable copper oxide. The barrier layer 137, in an example, prevents diffusion of the conductive material 139 to adjacent dielectric material of the interconnect layer 112. Furthermore, the barrier layer 137 facilitates better adhesion of the conductive material 139 on walls of the interconnect feature 114.

Note that in an example, the barrier layer 137 here is representative of a barrier layer, as well as a liner layer, a capping layer, and/or an encapsulation layer that may be present between conductive material of an interconnect feature and adjacent dielectric material.

In an example, the barrier layer 137 has a thickness in the range of 1 to 5 nanometers (nm), or 1 to 10 nm, or 0.5 to 20 nm, or 3 to 20 nm. In an example, the barrier layer 137 has a thickness of at least 1 nm, or at least 3 nm, or at least 5 nm, or at least 7 nm. In an example, the barrier layer 137 has a thickness of at most 5 nm, or at most 10 nm, or at most 20 nm, or at most 30 nm.

Suitable materials for the barrier layer 137 include barrier layer refractory metals and alloys, cobalt, cobalt-nickel (CoNi), ruthenium-cobalt combination, molybdenum, nickel, manganese, titanium-tungsten (Ti ), tantalum (Ta), tantalum-nitride (TaN), tantalum-silicon-nitride (TaSiN), titanium-nitride (TiN), titanium-silicon-nitride (TiSiN), tungsten (XV), tungsten-nitride (WN), tungsten-silicon-nitride (WiSiN), and/or combinations of such materials (e.g., a multi-lay stack of Ta/TaN). In an example, the conductive material 139 comprises suitable conductive materials such as pure copper, ruthenium, molybdenum, tungsten, aluminum, an alloy such as copper-tin (CuSn), copper indium (CuIn), copper-antimony (CuSb), copper-bismuth (CuBi), copper-rhenium (CuRe), and/or any other suitable conductive material.

In one embodiment, the IC 100 comprises a plurality of interconnect features 130 vertically extending through the device layer 106 and landing on corresponding interconnect features of the backside interconnect structure 120. The interconnect features 130 are also referred to herein as intermediate interconnect features 130, as the interconnect features 130 are in intermediate positions or between the front side interconnect features 114 and backside interconnect features 124.

In an example, one or more of the interconnect features 130 are deep conductive vias through the device layer 106, and connects the backside interconnect structure 120 to the transistors 104 and/or the front side interconnect structure 110. In an example, one or more other interconnect features 130 are buried or backside power rails (BPRs) to supply power to one or more of the transistors 104. In another example, one or more other interconnect features 130 land of BPRs (e.g., one of the interconnect features 124 is a BPR in such an example), to supply power from the BPRs to one or more of the transistors 104.

In one embodiment, the device layer 106 also comprises a plurality of conductors 129. In an example, one or more interconnect feature 130 are coupled to the interconnect structure 110 through corresponding one or more of the conductors 129. In an example, one or more other interconnect feature 129 are coupled to corresponding one or more transistors 104 through corresponding one or more of the conductors 129.

A section 111 of the IC 100 is identified using dotted lines in Fig. 1A, and Fig. 1B illustrates a magnified view of the section 111. Referring to Figs. 1A and 1B, the section 111 illustrates two interconnect features 124a and 124b of the backside interconnect structure 120, and an interconnect feature 130a extending through the device layer 106.

As illustrated in Figs. 1A and 1B, similar to the interconnect features 114x and 124x discussed herein earlier, the interconnect feature 130a also comprises conductive material 139. The barrier layer 137 separates the conductive material 139 of the interconnect feature 130a from adjacent dielectric material or semiconductor material of the device layer 106. Similarly, each of the interconnect features 124a, 124b comprises conductive material 139, and the barrier layer 137 separates the conductive material 139 of the interconnect features 124a, 124b from adjacent dielectric material of the corresponding interconnect layer 122.

In one embodiment, the interconnect feature 130a extends through the device layer 106 and conjoins the interconnect feature 124. In an example, the interconnect features 130a and 124a collectively form a continuous and monolithic body of conductive material 139. That is, there is no barrier layer or seam between the conductive materials of the interconnect features 130a and 124a. Thus, the conductive materials of the interconnect features 130a and 124a are in direct contact with each other, without any intervening barrier layer, liner layer, capping layer, or encapsulation layer. The barrier layers 137 of the two interconnect features 124a and 130a are continuous and conformal.

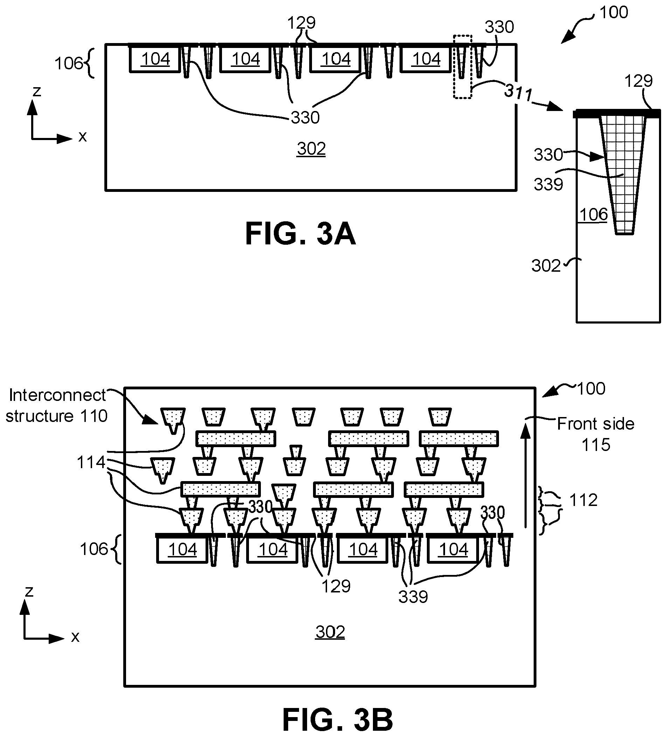

As illustrated in Fig. 1A, one or more of the interconnect features 114 of the front side interconnect structure 110 and one or more of the interconnect features 130 extending through the device layer 106 are tapered towards the bottom. For example, Fig. 1B illustrates the interconnect feature 130a having a width w1 at or near a top section of the interconnect feature 130a, and a width w2 at or near a bottom section of the interconnect feature 130a. The widths w1 and w2 are measured in a horizontal direction that is perpendicular to a vertical direction of an imaginary line passing through both the interconnect features 130a and 124a. The widths w1 and w2 are measured in a horizontal direction that is parallel to a plane of the device layer 106. Because the interconnect feature 130a is tapered towards the bottom, the width w1 is greater than the width w2. For example, as will be discussed with respect to Figs. 2 and 3A-3B, the recesses for the interconnect features 114 and 130 are formed from the top side of the IC 100, and hence, individual ones of the interconnect features 114 and 130 (e.g., interconnect feature 130a of Fig. 1B) are tapered towards the bottom. The extent of tapering may depend on the etch technology used to form a recess for the corresponding interconnect feature. In an example, in Fig. 1B, width w1 is greater than width w2 by at least 1%, or by at least 2%, or by at least 5%, or by at least 10%, or by at least 15%.

As illustrated in Figs. 1A and 1B, one or more of the backside interconnect features 124 of the backside interconnect structure 120 are tapered towards the top. For example, Fig. 1B illustrates the interconnect feature 124a having a width w3 at or near a top section of the interconnect feature 124a, and a width w4 at or near a bottom section of the interconnect feature 124a. The widths w3 and w3 are measured in a horizontal direction that is perpendicular to a vertical imaginary line passing through both the interconnect features 130a and 124a. The widths w3 and w4 are measured in a horizontal direction that is parallel to a plane of the device layer 106. Because the interconnect feature 124a is tapered towards the top, the width w3 is less than the width w4. For example, as will be discussed with respect to Figs. 2, 4, 3G, 5C and 5D, the recess for the interconnect feature 124a is formed from the bottom or backside of the IC 200, and hence, the interconnect feature 124a is tapered towards the top. The extent of tapering may depend on the etch technology used to form a recess for the interconnect feature 124a. In an example, width w3 is less than width w4 by at least 1%, or by at least 2%, or by at least 5%, or by at least 10%, or by at least 15%.

Thus, put differently, the interconnect feature 130a tapered towards the bottom is conjoined with the interconnect feature 124a tapered towards the top, such that the conductive materials of the interconnect features 130a and 124a are in direct contact with each other, without any intervening barrier layer, liner layer, capping layer, or encapsulation layer.

Fig. 2 illustrates a flowchart depicting a method 200 of forming an IC (such as the IC 100 of Figs. 1A and 1B) comprising a device layer 106 including a plurality of active and/or passive devices (such as transistors), and where one or more first interconnect features 130 extends vertically through the device layer 106 and conjoin with corresponding one or more backside interconnect features 124 on a backside of the device layer 106, wherein one of the first interconnect features 130 and one of the backside interconnect features 124 conjoin and collectively form a continuous and monolithic body of conductive material, in accordance with an embodiment of the present disclosure. Figs. 3A-3H illustrate cross-sectional views of an IC (such as the IC 100 of Figs. 1A, 1B, and 2) in various stages of processing, in accordance with an embodiment of the present disclosure. Figs. 2 and 3A-3H will be discussed in unison.

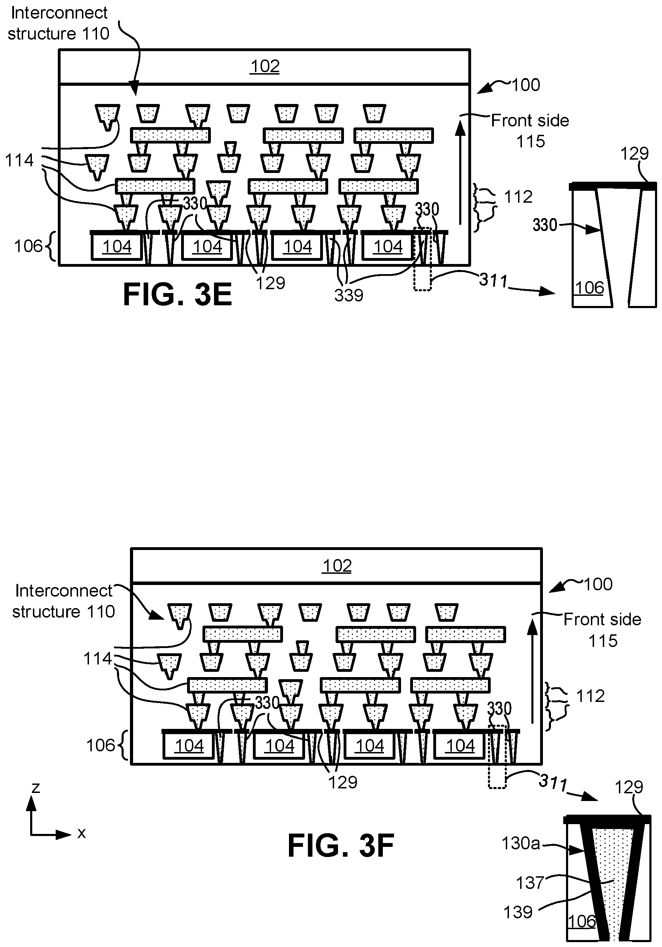

Referring to Fig. 2, the method 200 includes, at 204, forming a device layer 106 above a substrate 302, where a plurality of recesses 330 comprising sacrificial material 339 vertically extend through the device layer 106. Fig. 3A illustrate the substrate 302, and the device layer 106 above the substrate 302, where the device layer 106 comprises active and/or passive devices, such as transistors 104. The recesses 320 extend vertically through dielectric material and/or semiconductor material of the device layer 106. As illustrated in the magnified view on left side of Fig. 3A, an example recess 330 includes sacrificial material 339. Later in the process, the interconnect features 130 (see Figs. 1A, 1B) will be formed within the recesses 330. Note that there is no barrier layer or conductive material yet within the recesses 330. In an example, the sacrificial material 339 within the recesses 330 are etch selective to the dielectric and/or semiconductor material of the device layer 106, such that when the sacrificial material 339 are to be etched and removed later in the process (e.g., see Fig. 3E), the etching process may not substantially affect the adjacent dielectric and/or semiconductor material of the device layer 106.

Referring again to Fig. 2, the method 200 then proceeds from 204 to 208, where front side metallization is completed, to form the front side interconnect structure 110 above the device layer 130 and on the front side 115 of the IC 100. For example, Fig. 3B illustrates the interconnect structure 110 formed above the device layer 106, where the interconnect structure 110 comprise interconnect layers 112, and where individual interconnect layer 112 comprises dielectric material and conductive interconnect features 114 within the dielectric material, as discussed with respect to Fig. 1A. The interconnect structure 110 may be formed using any suitable technique for forming such interconnect structures. This completes the front side metallization of the IC 100.

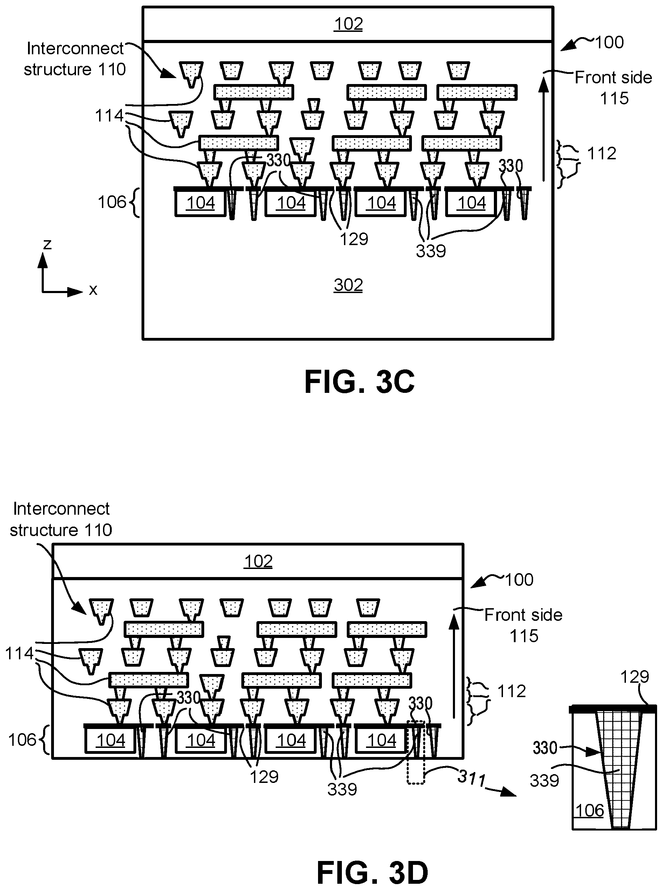

Referring again to Fig. 2, the method 200 proceeds from 208 to 212, where the front side of the IC 100 is bonded to a carrier wafer 102. Fig. 3C illustrates a top or front side of the IC 100 (i.e., the front side 115) bonded to the carrier wafer 102. The carrier wafer 102 allows the overall structure to be inverted, to facilitate subsequent backside processing. Note that such inversion is not depicted, so as to allow orientation language (such as above and below) to be used consistently for ease of description.

Referring again to Fig. 2, the method 200 proceeds from 212 to 226, where a sacrificial section of the substrate 302 below the device layer 106 is thinned and removed, to expose bottom surfaces of the recesses 330. Fig. 3D illustrates the substrate 302, such that the bottom surfaces of the recesses 330 are exposed through the bottom section of the IC 100. For example, Fig. 3D illustrates a magnified view of a section 311 of the IC 100, showing the bottom surface of the recess 330 being exposed. Note that the recesses 330 comprise sacrificial material 339. Any etching technique, such as an isotropic etching technique, may be used or the thinning process. In an example, the etch may be time based, such that the etching process is performed for a preconfigured amount of time until the bottom surfaces of the recesses 330 are exposed. In an example, over-etching may be performed, such that a small portion of bottom portions of the sacrificial material 339 of the recesses 330 (as well as a section of the device layer 106) may also be etched. In another example and although not illustrated in the figures, an etch stop layer may be present on the bottom surface of the device layer, which may act to stop the etching process.

Referring again to Fig. 2, the method 200 proceeds from 216 to 220, where the sacrificial material 339 from the recesses 330 are removed through the bottom surface of the IC 100, and interconnect features 130 are formed within the recesses 330. Fig. 3E illustrates the recesses 330, with the sacrificial material 339 removed form the recesses 330. An appropriate etching process, such as an isotropic etch process, can be performed. As previously discussed herein, the etching process selectively etches and removes the sacrificial material 339, without etching the bottom surface of the device layer 106.

Fig. 3F illustrates formation of the interconnect features 130 within the recesses 330. For example, as illustrated in the magnified view of section 311, sidewalls of individual recesses 311 are lined with the barrier layer 139, and then conductive material 139 (such as copper) are deposited within the recesses 330, to form the interconnect features 130. Note that the interconnect features 130 are not capped with a capping or encapsulation layer after deposition of the conductive material 139. Accordingly, there is no barrier layer 137 on bottom surface of the conductive materials 139 of the interconnect features 139, and the bottom surface of the conductive materials 139 of the interconnect features 139 are exposed through the bottom section of the IC 100, as illustrated in Fig. 3F.

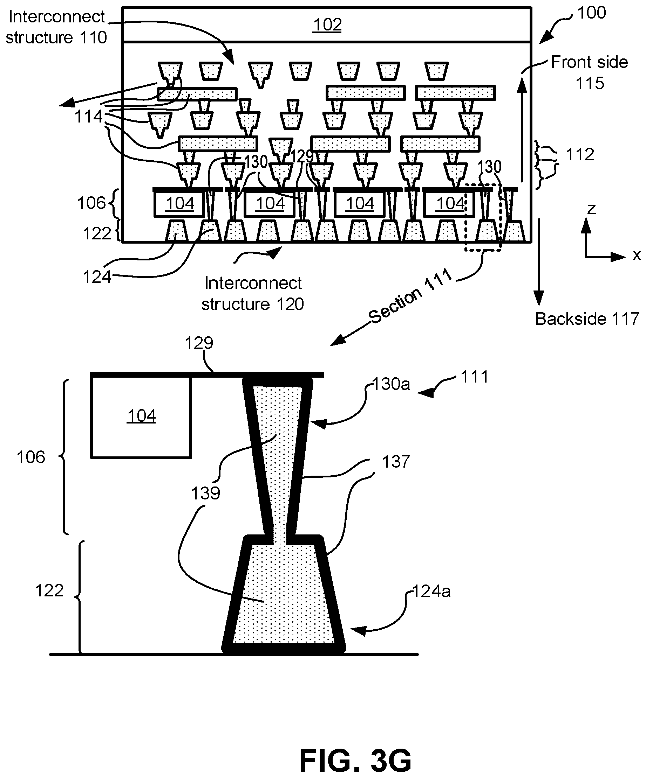

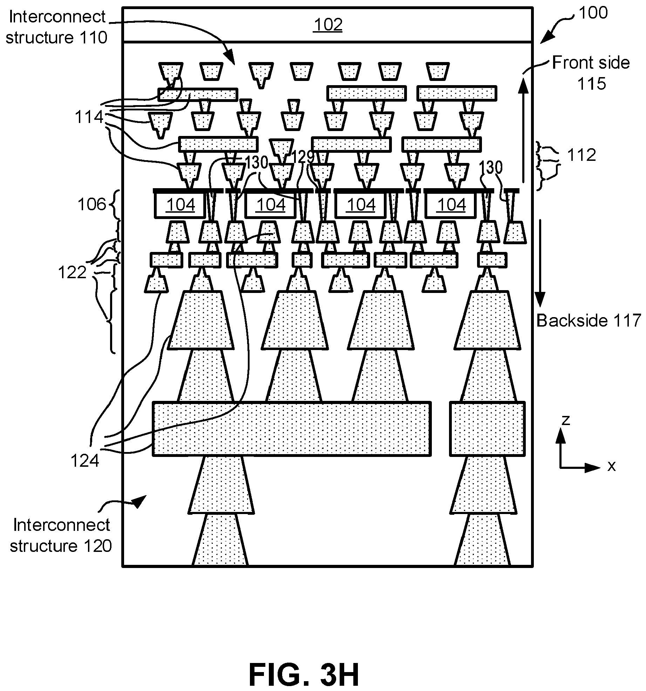

Referring again to Fig. 2, the method 200 proceeds from 220 to 224, where backside metallization is completed, to form the backside interconnect structure 120 below the device layer 130 and on the backside 117 of the IC 100. Figs. 3G and 3H illustrate the process 224 of forming the backside interconnect structure 120 below the device layer 130. For example, referring to Fig. 3G, a first interconnect layer 122 is formed, the first interconnect layer 122 comprising interconnect features 124. In Fig. 3G, an interconnect feature 124 conjoins with a corresponding one of the interconnect features 130. For example, as illustrated in the magnified view of the section 111, the interconnect features 130a and 124a collectively form a continuous and monolithic body of conductive material 139. That is, there is no barrier layer or seam between the conductive materials of the interconnect features 130a and 124a. This is because in Fig. 3F, the interconnect feature 130a did not have an encapsulation or barrier layer on a bottom surface of the interconnect feature 130a. Accordingly, when the interconnect feature 124a is formed (see Fig. 3G), the conductive materials 139 of the two interconnect features 130a and 124a form a continuous body of conductive material, without any barrier or encapsulation layer therebetween. Fig. 3H illustrates the complete backside interconnect structure 120, which is similar to the IC 100 of Fig. 1A.

In the method 200 of Fig. 2 and accompanying Figs. 3A-3H, the interconnect features 130 were completed first (see Fig. 3F), followed by formation of the backside interconnect layers 122. However, in another embodiment and as discussed herein below with respect to method 400 of Fig. 4, the interconnect features 130 can be formed along with formation of at least one backside interconnect layer 122. Thus, in this example, the continuous and monolithic body of conductive material of the interconnect features 130a and 124a is formed during a single deposition process.

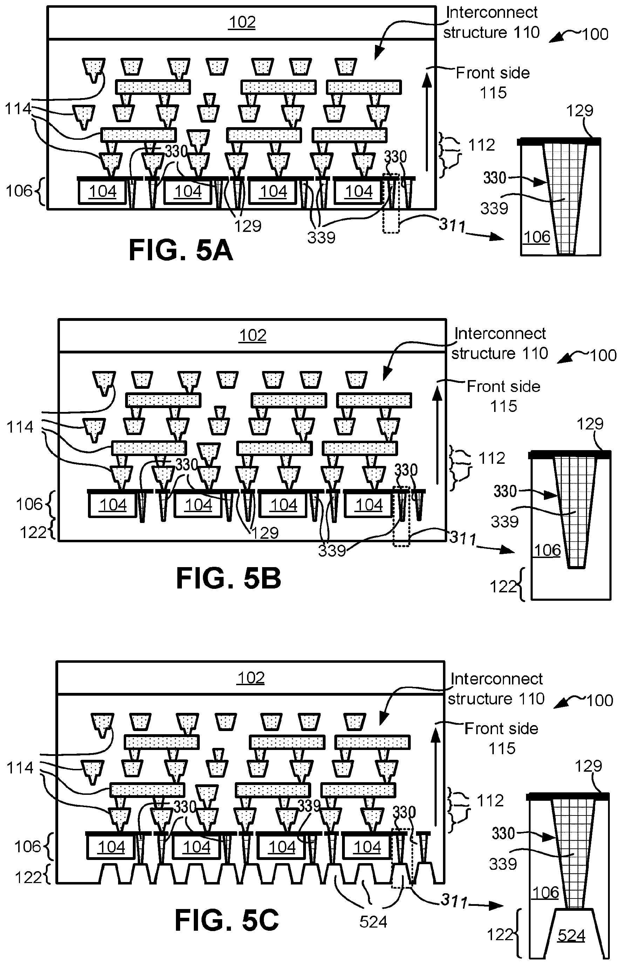

Fig. 4 illustrates a flowchart depicting a method 400 of forming an IC (such as the IC 100 of Figs. 1A and 1B) comprising a device layer 106 and one or more first interconnect features 130 extending vertically through the device layer 106 and conjoining with corresponding one or more backside interconnect features 124 on a backside of the device layer 106, wherein one of the first interconnect features 130 and one of the backside interconnect features 124 conjoin and collectively form a continuous and monolithic body of conductive material, and wherein the continuous and monolithic body of conductive material is formed during a same deposition process step, in accordance with an embodiment of the present disclosure. Figs. 5A-5F illustrate cross-sectional views of an IC (such as the IC 100 of Figs. 1A, 1B, and 4) in various stages of processing, in accordance with an embodiment of the present disclosure. Figs. 4 and 5A-5F will be discussed in unison.

Referring to Fig. 4, the method 400 includes processes 404, 408, 412, and 416, which are similar to the corresponding processes 204, 208, 212, and 216, respectively, of the method 200 of Fig. 2. Accordingly, processes 404, 408, 412, and 416 are not discussed in further detail herein. The process 416 of the method 400 of Fig. 4 results in formation of the IC 100 of Fig. 5A, which is similar to the structure of Fig. 3G formed by the process 216 of the method 200 of Fig. 2.

Referring again to Fig. 4, the method 400 proceeds from 416 to 420. At 420, dielectric material of a first backside interconnect layer 122 are deposited and recessed, such that one or more recesses 524 within the first backside interconnect layer 122 align with corresponding one or more recesses 330 extending through the device layer 106. For example, Fig. 5B illustrates deposition of the dielectric material of the first backside interconnect layer 122, where the first backside interconnect layer 122 is a backside interconnect layer that is adjacent to (or nearest to) and below the device layer 106. Fig. 5C illustrates the recesses 524 formed within the dielectric material of the first backside interconnect layer 122. As illustrated in the magnified view of section 311 in Figs. 5B and 5C (and as also discussed with respect to the method 200 of Fig. 2), the recesses 330 include the sacrificial material 339. Note that the sacrificial material 339 of the recesses 330 are exposed through the corresponding recesses 524, as illustrated in Fig. 5C.

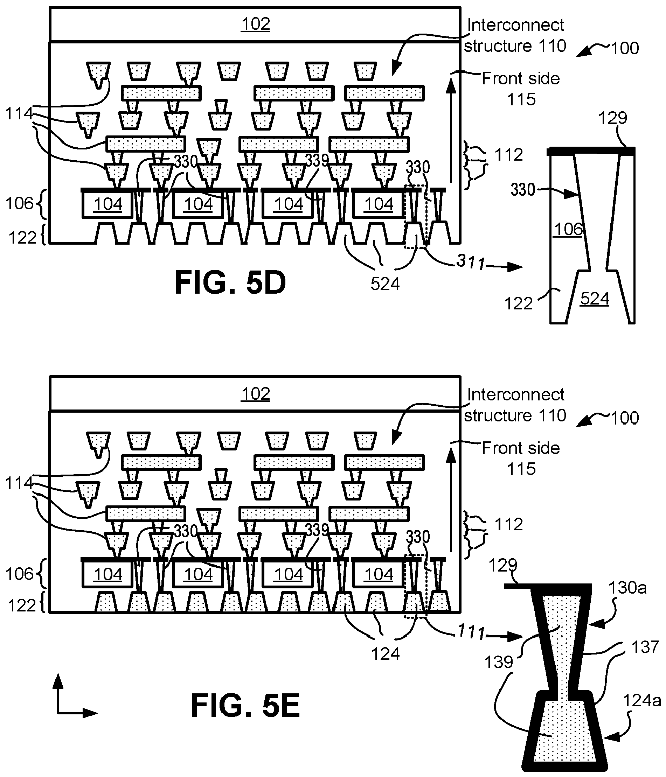

Referring again to Fig. 4, the method 400 proceeds from 420 to 424. At 424, the sacrificial material 339 are removed (e.g., by an etching process, as discussed with respect to process 220 of method 200 of Fig. 2) from the recesses 330, through the recesses 524 within the dielectric material of the first backside interconnect layer 122. Fig. 5D illustrates the IC 100, after the sacrificial material 339 have been removed from the recesses 330.

Referring again to Fig. 4, the method 400 proceeds from 424 to 428. At 428, conformal and continuous barrier layers 137 are deposited on walls of the recesses 330, 524, and conductive material 139 are deposited within the recesses 330, 524, to complete formation of (i) the interconnect features 130 and (ii) the interconnect features 124 of the first backside interconnect layer 122. Fig. 5E illustrates the IC 100, with the completed interconnect features 130 and the interconnect features 124 of the first backside interconnect layer 122. As seen in the magnified view of the section 111, a continuous and conformal barrier layer 137 is formed within the walls of the interconnect features 130a and 124a. Also, the conductive material 139 of the two interconnect features 130a and 124a are deposited in a single deposition process, resulting in the continuous and monolithic body of conductive material 139 of the two interconnect features 130a and 124a. In an example, the conductive material 139 comprises copper, and are deposited using an electroplating process. For example, a seed layer of copper is initially deposited on the barrier layer 137, and then the copper is grown using electroplating. In another example, any other suitable deposition process may be used to deposit the conductive material 139 with the recesses.

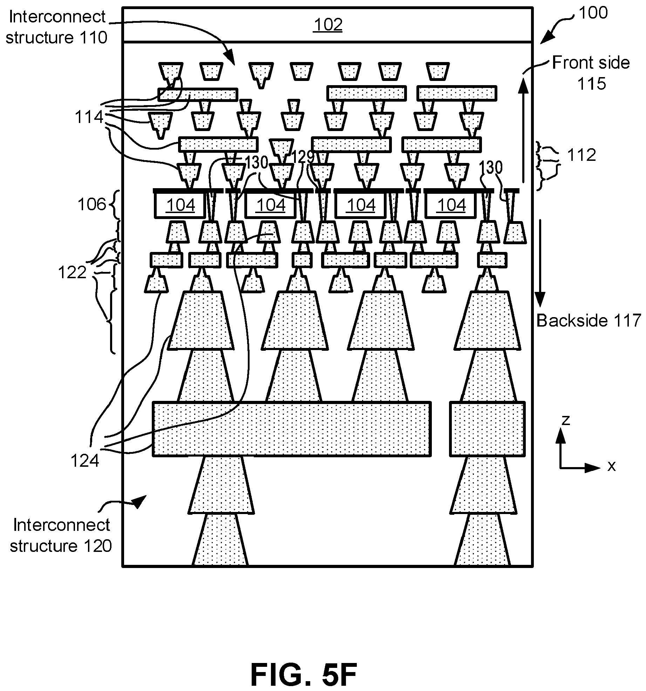

Referring again to Fig. 4, the method 400 proceeds from 428 to 432. At 432, backside metallization is completed, to form the backside interconnect structure 120 below the device layer 130 and on the backside 117 of the IC 100, e.g., as discussed with respect to process 224 of method 200 of Fig. 2. Fig. 5F illustrates the IC 100 including the completed backside interconnect structure 120 below the device layer 130 and on the backside 117 of the IC 100.

Note that the processes in method 400 are shown in a particular order for ease of description. However, one or more of the processes may be performed in a different order or may not be performed at all (and thus be optional), in accordance with some embodiments. Numerous variations on method 400 and the techniques described herein will be apparent in light of this disclosure.

In an example and as discussed with respect to Fig. 3A, the recesses 330 comprising the sacrificial material 339 are formed prior to, or concurrently with, forming the transistors 104. As discussed, the sacrificial material 339 of the recesses 330 are later replaced with the conductive material 139, to form the interconnect features 130. Note that the recesses 330 may be exposed to one or more relatively high temperature processes, during formation of the transistors 104 (e.g., during formation of gate stack of the transistors). If the recesses 330 were to be filed with conductive materials (e.g., instead of the sacrificial material 339) during formation of the transistors, such conductive material would have to sustain high thermal budget for processing of the transistors of the device layer 106 as well as the front side interconnect structures. This would have limited the choice of conductive materials to those that can sustain high thermal budget (such as ruthenium, molybdenum, cobalt, tungsten), which are not necessarily lowest resistance conductive material (such as copper). For example, using copper to form the interconnect features 139 directly in Fig. 3A (i.e., prior to, or concurrently with formation of the transistors 104) would have exposed the copper interconnect features to high temperature processing during transistor formation, thereby degrading the copper. In contrast, in accordance with various embodiments discussed herein, the sacrificial material of the recesses 330 are replaced with conductive material 139 much later during the formation of the IC 100 (e.g., see Figs. 3F and 5E), and hence, the conductive material 139 do not have to withstand the high temperature processing of the transistors 104. Instead, merely the sacrificial material 339 have to sustain the high temperature processing of the transistors 104. Accordingly, choice of the conductive material 139 need not be restricted to only those that can sustain high thermal budget. Accordingly, conductive materials, which cannot sustain high thermal budget and that are relatively low in resistance, such as copper, can also be used for the interconnect feature 130. This results in relatively low resistance of the copper-based interconnect features 130 (e.g., compared to a scenario where ruthenium, molybdenum, cobalt, or tungsten were to be used). Furthermore, due to the manner in which the interconnect feature 130 are formed, there is no barrier layer between the interconnect feature 130 and the corresponding backside interconnect features 124, which further reduces the resistance of the interconnect features 130.

### Example System

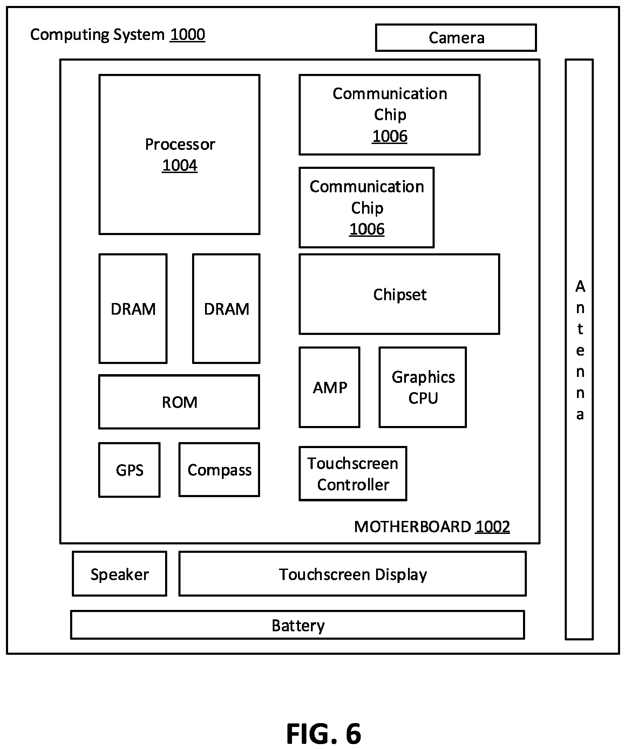

Fig. 6 illustrates a computing system 1000 implemented with integrated circuit structures and/or the interconnect features formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following clauses pertain to further embodiments, from which numerous permutations and configurations will be apparent.
Example 1. An integrated circuit device comprising: a device layer including a plurality of transistors; a first interconnect feature vertically extending through the device layer; and an interconnect structure below the device layer, the interconnect structure including at least a second interconnect feature that is conjoined with the first interconnect feature, wherein the first and second interconnect features collectively form a continuous and monolithic body of conductive material.
Example 2. The integrated circuit of claim 1, further comprising: a continuous conformal layer on walls of the first and second interconnect features.
Example 3. The integrated circuit of claim 2, wherein the continuous conformal layer comprises a barrier layer separating the body of conductive material from adjacent dielectric material.
Example 4. The integrated circuit structure of any of claims 2-3, wherein the continuous conformal layer comprises one or more of cobalt, nickel, ruthenium, molybdenum, manganese, titanium, tungsten, tantalum, nitrogen, silicon.
Example 5. The integrated circuit structure of any of claims 1-4, wherein the conductive material comprises copper.
Example 6. The integrated circuit structure of any of claims 1-5, wherein the conductive material comprises one or more of copper, ruthenium, molybdenum, tin, indium, antimony, or bismuth.
Example 7. The integrated circuit structure of any of claims 1-6, further comprising: a first plurality of interconnect features vertically extending through the device layer, the first plurality of interconnect features including the first interconnect feature, wherein one or more of the first plurality of interconnect features are conductive vias that couple the interconnect structure to corresponding one or more transistors of the plurality of transistors, through one or more conductors of the device layer.
Example 8. The integrated circuit structure of any of claims 1-7, wherein the second interconnect feature of the interconnect structure below the device layer is a buried or backside power rail (BPR) that is to supply power, through the first interconnect feature, to a corresponding transistor of the plurality of transistors.
Example 9. The integrated circuit structure of any of claims 1-8, further comprising: a first plurality of interconnect features vertically extending through the device layer, the first plurality of interconnect features including the first interconnect feature, wherein one of the first plurality of interconnect features is a buried or backside power rail (BPR) to supply power to a corresponding transistor of the plurality of transistors.
Example 10. The integrated circuit structure of any of claims 1-9, further comprising: a first plurality of interconnect features vertically extending through the device layer, the first plurality of interconnect features including the first interconnect feature, wherein the interconnect structure is a first interconnect structure that includes one or more first interconnect layers, the one or more first interconnect layers including a second plurality of interconnect features including the second interconnect feature; and a second interconnect structure above the device layer and including one or more second interconnect layers, the one or more second interconnect layers including a third plurality of interconnect features including a third interconnect feature.
Example 11. The integrated circuit structure of claim 10, wherein the first interconnect feature is a conductive via coupling the second interconnect feature of the first interconnect structure and a third interconnect feature of the second interconnect structure.
Example 12. The integrated circuit structure of any of claims 10-11, further comprising: a plurality of input/output pins below the first interconnect structure, the plurality of input/output pins coupling the integrated circuit structure to a printed circuit board.
Example 13. The integrated circuit device of claim 12, wherein one or more of the second plurality of interconnect features route signals (i) between the plurality of transistors and (ii) from or to one or more input or output (I/O) pins.
Example 14. The integrated circuit device of any of claims 10-13, wherein one or more of the third plurality of interconnect features route signals between the plurality of transistors.
Example 15. The integrated circuit device of any of claims 10-14, wherein one or more of the second plurality of interconnect features route power to the plurality of transistors.
Example 16. The integrated circuit of any of claims 1-15, wherein one or more transistors of the plurality of transistors are nanoribbon or nanosheet transistors, and include wrap around gate structures.
Example 17. An integrated circuit device comprising: a first interconnect feature tapered towards the bottom, such that a first width of the first interconnect feature measured at or near a top surface of the first interconnect feature is at least 5% greater than a second width of the first interconnect feature measured at or near a bottom surface of the first interconnect feature; and a second interconnect feature tapered towards the top, such that a third width of the second interconnect feature measured at or near a top surface of the second interconnect feature is at least 5% less than a fourth width of the second interconnect feature measured at or near a bottom surface of the second interconnect feature, wherein the first, second, third, and fourth widths are measured in a horizontal direction that is perpendicular to an imaginary line passing through the first and second interconnect features, and wherein the first and second interconnect features collectively form a continuous and monolithic body of conductive material.
Example 18. The integrated circuit of claim 17, further comprising: a continuous conformal layer on the walls of the first and second interconnect features.
Example 19. The integrated circuit of claim 18, wherein the continuous conformal layer on the walls of the first and second interconnect features is absent between at least a section of a junction between the first and second interconnect features.
Example 20. The integrated circuit of any of claims 17-19, further comprising: a device layer comprising a plurality of transistors, wherein the first interconnect feature at least in part extends through the device layer.
Example 21. The integrated circuit of claim 20, further comprising: a backside interconnect structure below the device layer, the backside interconnect structure including one or more interconnect layers, the one or more interconnect layers including a plurality of interconnect features including the second interconnect feature.
Example 22. The integrated circuit of any of claims 17-21, further comprising: a device layer comprising a plurality of transistors; and a front side interconnect structure above the device layer, the front side interconnect structure including one or more front side interconnect layers, the one or more front side interconnect layers including a plurality of front side interconnect features.
Example 23. The integrated circuit of claim 22, wherein the first interconnect feature couples the second interconnect feature below the device layer to the front side interconnect structure above the device layer.
Example 24. A microelectronic device comprising: a device layer comprising a plurality of transistors; a backside interconnect structure below the device layer and on a backside of the plurality of transistors, the backside interconnect structure comprising a plurality of backside interconnect features including a first backside interconnect feature; a front side interconnect structure above the device layer and on a front side of the plurality of transistors, the front side interconnect structure comprising a plurality of front side interconnect features including a first front side interconnect feature; and an intermediate interconnect feature between the backside interconnect structure and the front side interconnect structure and extending at least in part through the device layer, the intermediate interconnect feature coupling the first backside interconnect feature and the first front side interconnect feature, wherein the intermediate interconnect feature and the first backside interconnect feature are conjoined, such that there is no intervening layer between conductive materials of the intermediate interconnect feature and the first backside interconnect feature.
Example 25. The microelectronic device of claim 24, further comprising: a barrier layer on walls of the intermediate interconnect feature and the first backside interconnect feature, wherein the barrier layer is absent between the conductive materials of the intermediate interconnect feature and the first backside interconnect feature.
Example 26. The microelectronic device of any of claims 24-25, wherein the conductive materials of the intermediate interconnect feature and the first backside interconnect feature comprise copper.
Example 27. The microelectronic device of any of claims 24-26, further comprising: a plurality of input/output (I/O) pins below the backside interconnect structure, to couple the microelectronic device to a printed circuit board.
Example 28. A method of forming an integrated circuit, comprising: forming, on a substrate, a device layer comprising a plurality of transistors and a recess filed with sacrificial material; forming a front side interconnect structure above the device layer and including one or more front side interconnect layers, the one or more front side interconnect layers including front side conductive interconnect features; removing a section of the substrate under the device layer, so as to expose a bottom surface of the recess; and removing the sacrificial material from the recess and forming an intermediate interconnect feature within the recess; and forming a backside interconnect structure below the device layer, the backside interconnect structure including one or more backside interconnect layers, the one or more backside interconnect layers including backside conductive interconnect features, wherein a first backside conductive interconnect feature conjoins with the intermediate interconnect feature to collectively form a continuous and monolithic body of conductive material.
Example 29. The method of claim 28, wherein removing the sacrificial material from the recess and forming the intermediate interconnect feature within the recess comprises: depositing dielectric material of a first backside interconnect layer and forming a plurality of backside recesses within the dielectric material of the first backside interconnect layer, wherein a first backside recess is aligned with the recess filed with the sacrificial material, such that the sacrificial material within the recess is exposed through the first backside recess; and removing the sacrificial material from the recess, through the first backside recess.
Example 30. The method of claim 29, wherein forming the intermediate interconnect feature further comprises: depositing, through the first backside recess, a barrier layer on walls of the recess and the first backside recess; and depositing, through the first backside recess, conductive material within the recess and the first backside recess, to respectively form the first backside conductive interconnect feature and the intermediate interconnect feature within the first backside recess and the recess.
Example 31. The method of any of claims 28-30, further comprising: prior to removing the section of the substrate under the device layer, bonding a carrier wafer above the first interconnect structure.
Example 32. The method of any of claims 28-31, further comprising: forming input/output (I/O) pins below the backside interconnect structure, the I/O pins to conduct signals and power between the device layer and a printer circuit board.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner, and may generally include any set of one or more limitations as variously disclosed or otherwise demonstrated herein.

## Claims

1. An integrated circuit device comprising:
a device layer including a plurality of transistors;
a first interconnect feature vertically extending through the device layer; and
an interconnect structure below the device layer, the interconnect structure including at least a second interconnect feature that is conjoined with the first interconnect feature,
wherein the first and second interconnect features collectively form a continuous and monolithic body of conductive material.

2. The integrated circuit of claim 1, further comprising:
a continuous conformal layer on walls of the first and second interconnect features.

3. The integrated circuit of claim 2, wherein the continuous conformal layer comprises a barrier layer separating the body of conductive material from adjacent dielectric material.

4. The integrated circuit structure of claim 2 or 3, wherein the continuous conformal layer comprises one or more of cobalt, nickel, ruthenium, molybdenum, manganese, titanium, tungsten, tantalum, nitrogen, silicon.

5. The integrated circuit structure of any one of claims 1 through 4, wherein the conductive material comprises copper.

6. The integrated circuit structure of any one of claims 1 through 5, further comprising:
a first plurality of interconnect features vertically extending through the device layer, the first plurality of interconnect features including the first interconnect feature,
wherein one or more of the first plurality of interconnect features are conductive vias that couple the interconnect structure to corresponding one or more transistors of the plurality of transistors, through one or more conductors of the device layer.

7. The integrated circuit structure of any one of claims 1 through 6, wherein the second interconnect feature of the interconnect structure below the device layer is a buried or backside power rail (BPR) that is to supply power, through the first interconnect feature, to a corresponding transistor of the plurality of transistors.

8. The integrated circuit structure of any one of claims 1 through 7, further comprising: a first plurality of interconnect features vertically extending through the device layer, the first plurality of interconnect features including the first interconnect feature, wherein one of the first plurality of interconnect features is a buried or backside power rail (BPR) to supply power to a corresponding transistor of the plurality of transistors.

9. The integrated circuit structure of any one of claims 1 through 8, further comprising:
a first plurality of interconnect features vertically extending through the device layer, the first plurality of interconnect features including the first interconnect feature,
wherein the interconnect structure is a first interconnect structure that includes one or more first interconnect layers, the one or more first interconnect layers including a second plurality of interconnect features including the second interconnect feature; and
a second interconnect structure above the device layer and including one or more second interconnect layers, the one or more second interconnect layers including a third plurality of interconnect features including a third interconnect feature.

10. The integrated circuit structure of claim 9, wherein the first interconnect feature is a conductive via coupling the second interconnect feature of the first interconnect structure and a third interconnect feature of the second interconnect structure.

11. The integrated circuit structure of claim 9 or 10, further comprising:
a plurality of input/output pins below the first interconnect structure, the plurality of input/output pins coupling the integrated circuit structure to a printed circuit board.

12. The integrated circuit device of claim 11, wherein:
one or more of the second plurality of interconnect features route signals (i) between the plurality of transistors and (ii) from or to one or more input or output (I/O) pins.

13. The integrated circuit device of any one of claims 9 through 12, wherein one or more of the third plurality of interconnect features route signals between the plurality of transistors.

14. The integrated circuit device of any one of claims 9 through 13, wherein one or more of the second plurality of interconnect features route power to the plurality of transistors.

15. The integrated circuit of any of claims 1 through 14, wherein one or more transistors of the plurality of transistors are nanoribbon or nanosheet transistors, and include wrap around gate structures.
